# EUROPEAN PATENT SPECIFICATION

(11) **EP 2 575 135 B1**
(45) Date of publication and mention of the grant of the patent: **05.08.2015**
(21) Application number: 11290444.6
(22) Date of filing: 28.09.2011
(51) Int. Cl.: G11C 11/16

(54) **Magnetic random access memory (MRAM) cell and method for reading the MRAM cell using a self-referenced read operation**
Magnetdirektzugriffsspeicherzelle (MRAM-Zelle) und Verfahren zum Lesen einer MRAM-Zelle mittels selbstbezogener Leseoperation
Cellule de mémoire à accès aléatoire magnétique (MRAM) et procédé de lecture de cellule MRAM utilisant une opération de lecture auto-référencée

(43) Date of publication of application: 03.04.2013
(73) Proprietor: Crocus Technology S.A., 38025 Grenoble Cedex (FR)
(72) Inventor: Lombard, Lucien, 38000 Grenoble (FR); Prejbeanu, Ioan Lucian, 38170 Seyssinet Pariset (FR)
(74) Representative: P&TS SA (AG, Ltd.)

(56) References cited:
- WO-A2-03/049120
- US-A1- 2005 152 178
- US-A1- 2008 180 992

## Description

### Field

The present invention concerns a method for reading a magnetic random access memory (MRAM) cell using a self-referenced read operation allowing for low consumption and a MRAM cell for performing the method.

### Description of related at

In the simplest implementation, magnetic random access memory (MRAM) cells comprise at least a magnetic tunnel junction formed of two magnetic layers separated by a thin insulating layer, where one of the layer, the so-called reference layer, is characterized by a fixed magnetization and the second layer, the so-called storage layer, is characterized by a magnetization which direction can be changed upon writing of the memory. When the respective magnetisations of the reference layers and the storage layer are antiparallel, the resistance of the magnetic tunnel junction is high (Rₘₐₓ), corresponding to a low logic state "0". On the other hand, when the respective magnetizations are parallel, the resistance of the magnetic tunnel junction becomes low (Rₘᵢₙ), corresponding to a high logic state "1". The logic state of the MRAM cell is read by comparing its resistance state to a reference resistance R_{ref}, preferably derived from a reference cell or an array of reference cells, with a reference resistance of typically R_{red} = (Rₘᵢₙ+Rₘₐₓ)/2, combined in-between the magnetic tunnel junction resistance of the high logic state "1" and the resistance of the low logic state "0".

In conventional practical implementations, the reference layer is "exchange biased" to an adjacent antiferromagnetic reference layer characterized by a critical temperature (above which the exchange bias vanishes) known as the blocking temperature T_{BR} of the antiferromagnetic reference layer.

In an implementation of the MRAM cell using a thermally assisted switching (TAS) procedure, for example as described in U.S. Patent No. 6,950,335, the storage layer is also exchange biased to an adjacent antiferromagnetic storage layer which blocking temperature T_{BS} (the temperature at which the exchange bias of the antiferromagnetic storage layer vanishes) is lower than that the blocking temperature T_{BR} of the antiferromagnetic reference layer pinning the reference layer. Below the blocking temperature T_{BS}, the storage layer is difficult and/or impossible to write. Writing is then performed by heating the magnetic tunnel junction above T_{BS} but below T_{BR}, preferably but not limited to by sending a heating current through the magnetic tunnel junction, in order to free the magnetization of the storage layer, while simultaneously applying means of switching the magnetization of the storage layer. The latter can be performed either by a magnetic field, generated by a field current. The magnetic tunnel junction is then cooled down below the blocking temperature T_{BS}, where the storage layer magnetization is "frozen" in the written direction.

The magnetic field magnitude required to switch the magnetization direction of the storage layer is proportional to the coercivity of the storage layer, which is large at small feature sizes and can be greatly enhanced in exchange biased films.

In patent publication EP2276034, the present application discloses a MRAM cell comprising the storage layer, insulating layer and a sense layer having a magnetization which direction can be freely aligned in a magnetic field. The disclosed MRAM cell can be written by switching a magnetization direction of the storage layer to write data to said storage layer. A read operation can comprise a first read cycle including aligning the magnetization direction of the sense layer in a first aligned direction and comparing said write data with said first aligned direction by measuring a first resistance value of the MRAM cell. The read operation can further comprise a second read cycle including aligning the magnetization of the sense layer in a second aligned magnetization direction, comparing the write data with the second aligned direction by measuring a second resistance value of the MRAM cell; and determining a difference between the first resistance value and the second resistance value. The read operation is also called "self-referenced read operation" since the use of a conventional reference cell is not required.

The disclosed memory cell and write-read operation method allow for performing the write and read operations with low power consumption and an increased speed. However, during the self-referenced read operation a dipolar coupling between the storage and sense layers occurs due to local magnetic stray field, coupling the magnetization of the storage and sense layers in a closed magnetic flux configuration. Since during the read operation the storage layer magnetization is pinned by the antiferromagnetic layer, the sense layer magnetization will then be also pinned through the coupling. Switching the sense layer magnetization during the self-referenced read operation will then require applying a magnetic field high enough to overcome the dipolar coupling. The dipolar coupling results in a shift (or bias) of the hysteresis loop when applying a field cycle to measure the hysteresis loop of the sense layer.

This dipolar coupling depends on the thickness and magnetization of the storage and sense layers, and on the size of the magnetic tunnel junction. In particular, dipolar coupling increases with decreasing the magnetic tunnel junction diameter and can thus become a major issue when scaling down the MRAM cell.

### Brief summary

The present disclosure concerns a magnetic random access memory (MRAM) cell comprising a magnetic tunnel junction comprising:
a synthetic storage layer formed from a first ferromagnetic layer having a first storage magnetization, a second ferromagnetic layer having a second storage magnetization and a spacer layer between the first and second storage layers, the spacer layer magnetically coupling the first and second ferromagnetic layers such that the first storage magnetization is oriented substantially anti-parallel with the second magnetization;
a sense layer having a sense magnetization that is reversible; and
a tunnel barrier layer between the sense layer and the storage layer;
the first storage magnetization inducing a first local magnetic stray field and the second storage magnetization inducing a second local magnetic stray field, the difference between the first and second local magnetic stray fields corresponding to a net local magnetic stray field coupling the storage layer with the sense layer;
the thickness of the first ferromagnetic layer and the thickness of the second ferromagnetic layer being selected such that the net local magnetic stray field coupling the sense layer is below about 50 Oe.

In an embodiment, the thickness of the first ferromagnetic layer and the thickness of the second ferromagnetic layer are selected such that the net local magnetic stray field coupling the sense layer is substantially null.

In another embodiment, the thickness of the first ferromagnetic layer and the thickness of the second ferromagnetic layer are selected such that the net local magnetic stray field coupling the sense layer is comprised between about 40 Oe and about 50 Oe.

In yet another embodiment, the sense layer has a substantially circular shape.

The present disclosure also concerns a magnetic memory device comprising a plurality of the MRAM cells.

The present disclosure further concerns a method for writing the MRAM cell, comprising: heating the magnetic tunnel junction to a high temperature threshold; and, once the magnetic tunnel junction has reached the high temperature threshold, switching the magnetisation direction of the first and second storage magnetizations to write data to said storage layer; wherein switching the magnetization direction of the first and second storage magnetizations comprises applying an external write magnetic field.

In an embodiment, the write magnetic field is applied with a magnitude that is comprised between about 130 Oe and about 160 Oe.

In another embodiment, said switching the first and second storage magnetizations comprises applying the external write magnetic field having a magnitude such as to saturate the sense magnetization in a direction according to the direction of the write magnetic field; the first and second storage magnetizations being switched in accordance with a local sense magnetic stray field induced by the saturated sense magnetization.

In yet another embodiment, the thickness of the sense layer is such that the sense magnetization is greater than the sum of the first and second storage magnetizations.

In yet another embodiment, the thickness of the sense layer is such that the magnitude of the write magnetic field required to saturate the sense magnetization is below about 80 Oe.

The present disclosure further pertains to a method for reading the MRAM cell, comprising:
aligning the sense magnetization in a first direction by applying a first read magnetic field;
measuring a first resistance of said magnetic tunnel junction, the first resistance being determined by the first direction of the sense magnetization relative to the orientation of switched the storage magnetization;
aligning the sense magnetization in a second direction;
measuring a second resistance of said magnetic tunnel junction, the second resistance being determined by the second direction of the sense magnetization relative to the orientation of the switched storage magnetization;
determining a difference between the first resistance value and the second resistance value;
said aligning the sense magnetization in a second direction comprises applying a second read magnetic field having a magnitude of about 50 Oe or below.

In an embodiment, the thickness of the first ferromagnetic layer and the thickness of the second ferromagnetic layer are selected such that the net local magnetic stray field coupling the sense layer is substantially null.

In another embodiment, the magnitude of the first and second read magnetic fields is about 20 Oe.

In yet another embodiment, the thickness of the first ferromagnetic layer and the thickness of the second ferromagnetic layer are selected such that the net local magnetic stray field coupling the sense layer is comprised between about 40 Oe and about 50 Oe.

In yet another embodiment, the second read magnetic field is substantially null.

The disclosed MRAM cell can be written and read with lower consumption in comparison to conventional MRAM cells.

### Brief Description of the Drawings

The disclosure will be better understood with the aid of the description of an embodiment given by way of example and illustrated by the figures, in which;
Fig. 1 illustrates a random access memory (MRAM) cell comprising a synthetic storage layer including a first ferromagnetic layer, a second ferromagnetic layer and a sense layer, according to an embodiment;
Fig. 2 represents local magnetic stray fields generated by the first and second ferromagnetic layers and coupling with the sense layer, according to an embodiment;
Fig. 3 shows a top view of the storage layer having a substantially circular shape, according to an embodiment; and
Figs. 4 (a) and (b) shows a configuration of the MRAM cell wherein the thickness of the second ferromagnetic layer is larger than the thickness of the first ferromagnetic layer (Fig. 4. (a)) and wherein the thickness of the first ferromagnetic layer is larger than the thickness of the second ferromagnetic layer (Fig. 4 (b)).

### Detailed Description of possible embodiments of the Invention

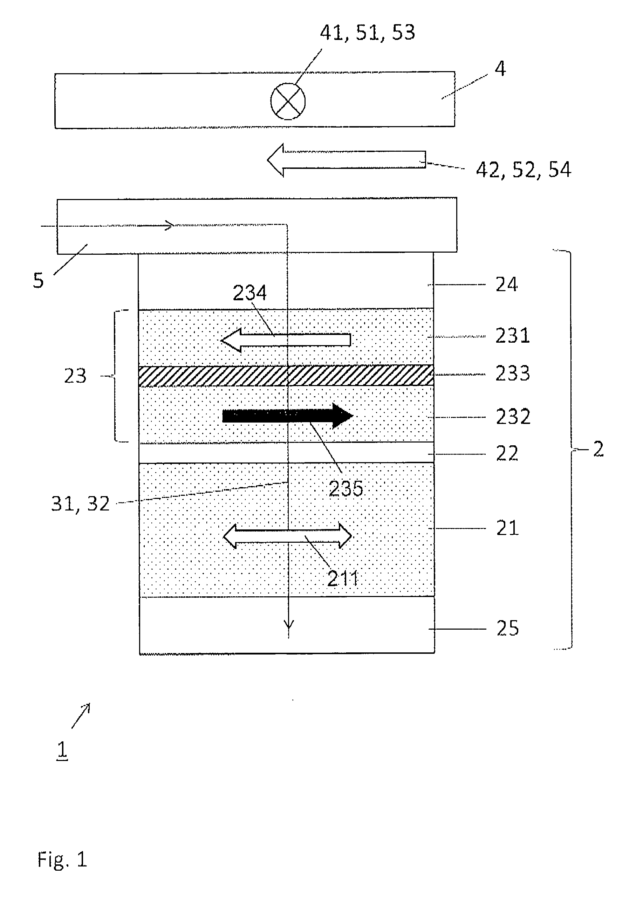

In an embodiment illustrated in Fig. 1, a magnetic random access memory (MRAM) cell 1 comprising a magnetic tunnel junction 2. The magnetic tunnel junction 2 comprises a synthetic storage layer 23 formed from a synthetic ferromagnetic multilayer comprising a first ferromagnetic layer 231 having a first storage magnetization 234, a second ferromagnetic layer 232 having a second storage magnetization 235, the first and second ferromagnetic layers 231, 232 being separated by a spacer layer 233. The ferromagnetic layers 231 and 232 may be made of a material such as, for example, cobalt iron (CoFe), cobalt iron bore (CoFeB), nickel iron (NiFe), Cobalt (Co), etc. The thickness of the first and second ferromagnetic layer 231, 232 can be comprised, for example, between 1 nm and 10 nm.

The dimensions (e.g., thickness) of the spacer layer 233 may be selected to cause the first and second ferromagnetic layers 231 and 232 to be magnetically coupled, such that the first storage magnetization 234 is oriented anti-parallel with the second magnetization 235. The thickness may depend on the material that the spacer layer 233 is formed from. For example, the spacer layer 233 can be made from a non-magnetic material selected from the group comprising, for example, ruthenium (Ru), rhenium (Re), rhodium (Rh), tellurium (Te), yttrium (Y), chromium (Cr), iridium (Ir), silver (Ag), copper (Cu), etc. In an embodiment, the thickness may be between about 0.2 nm and 3 nm. However, other thicknesses may be suitable to couple the two ferromagnetic layers 231 and 232.

In the exemplary configuration of Fig. 1, the synthetic storage layer 23 is exchange coupled with an antiferromagnetic layer 24 such as to pin the first storage magnetization 234 of the first ferromagnetic layer 231 at a low temperature threshold and to free it at a second high temperature threshold. The antiferromagnetic layer 24 can be made from a manganese-based alloy, such as IrMn, PtMn or FeMn, or any other suitable materials.

The magnetic tunnel junction 2 further comprises a sense layer 21 having a sense magnetization 211 that is reversible, and a tunnel barrier layer 22 separating the sense layer 21 from the storage layer 23. The sense layer 21 can be made of NiFe-based alloys instead of CoFeB-based alloys in order to obtain a lower switching field. The sense layer 21 is not exchange biased and its magnetization has a direction that can be varied freely, for example, due to thermal agitation and thus, its magnetization can be freely aligned in a magnetic field. The tunnel barrier layer 22 is a thin layer, typically in the nanometer range and can be formed, for example, from any suitable insulating material, such as alumina or magnesium oxide. In Fig. 1, the layer 25 represents an electrode.

In an embodiment, the synthetic storage layer 23, or the first and second ferromagnetic layer 231, 232, has a magnetocrystalline anisotropy that is oriented substantially parallel to the magnetocrystalline anisotropy of the sense layer 21. Moreover, the magnetocrystalline anisotropy of the synthetic storage layer 23 can also be substantially parallel to the direction of the first read magnetic field 51.

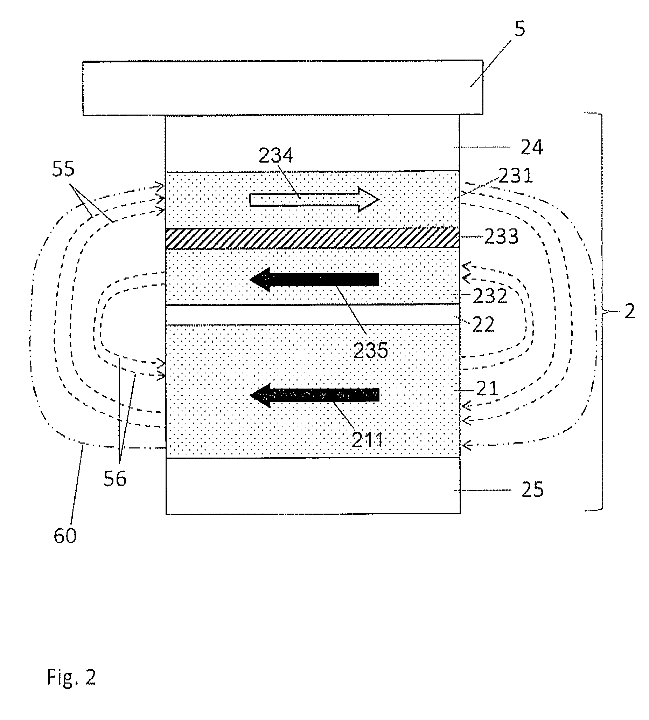

A dipolar coupling can occur between the storage layer 23 and the sense layer 21. Such dipolar coupling is caused by a first local magnetic stray field 55 induced by the first storage magnetization 234 and a second local magnetic stray field 56 induced by the second storage magnetization 235. Fig. 2 represents the first and second local magnetic stray fields 55, 56 coupling the first and second storage magnetizations 234, 235 with the sense magnetization 211 of the sense layer 21 in a closed magnetic flux configuration. The magnitude of the dipolar coupling, or the net local magnetic stray field, corresponds to the sum of the first and second local magnetic stray fields 55, 56. In turn, the magnitude of the first local magnetic stray field 55 depends on the first storage magnetization 234 and the magnitude of the second local magnetic stray field 56 depends on the second storage magnetization 235. The first storage magnetization 234 varies with the thickness t1 of the first ferromagnetic layer 231 and the second storage magnetization 235 varies with the thickness t2 of the second ferromagnetic layer 232, The first and second storage magnetizations 234, 235 can also be varied, for example, by selecting magnetic materials having various spontaneous magnetizations such as, but not exclusively, Fe, Co, Ni and their alloys such as FeCo, NiFe, FeCoB, FeCoNi or FeCoCr. Due to the anti-parallel coupling between first and second ferromagnetic layers 231, 232, the first and second storage magnetizations 234, 235 are oriented in the opposite directions. The net local magnetic stray field coupling the sense layer 21 will then corresponds to the difference between the two local magnetic stray fields 55, 56.

According to an embodiment, a thermally assisted switching (TAS) write operation comprises:
heating the magnetic tunnel junction 2 to a high temperature threshold;
once the magnetic tunnel junction 2 has reached the high temperature threshold, switching the first and second storage magnetizations 234, 235 in the written state (write data); and
cooling the magnetic tunnel junction 2 to the low temperature threshold such as to freeze the first and second storage magnetizations 234, 235 in the written state.

More particularly, the magnetic tunnel junction 2 can be heated by applying a heating current 31 through the magnetic tunnel junction 2 via a current line 5. The magnetic tunnel junction 2 can be heated to a high temperature threshold lying above a critical temperature Tc, where the exchange coupling between the antiferromagnetic layer 24 and the first ferromagnetic layer 231 disappears and the first storage magnetization 234 is no more pinned. Simultaneously or after a short time delay, once the magnetic tunnel junction 2 has reached the high temperature threshold, an external write magnetic field 42 is applied such as to switch the first and second storage magnetizations 234, 235 according to the write magnetic field 42, In particular, the greater of the first storage magnetization 234 and the second storage magnetization 235 will be aligned by the write magnetic field 42. At the high temperature threshold, the first and second ferromagnetic layers 231, 232 remain magnetically coupled due to the spacer layer 233 and the second storage magnetization 235 remains antiparallel to the first storage magnetization 234. Switching the first and second storage magnetizations 234, 235 can be performed with the write magnetic field 42 having a magnitude comprised typically between about 130 Oe and about 160 Oe.

After the temperature of the magnetic tunnel junction 2 has reached the high temperature threshold, the heating current 31 can be inhibited such as to cool the magnetic tunnel junction 2. The write magnetic field 42 can be maintained during the cooling of the magnetic tunnel junction 2 and switched off once the magnetic tunnel junction 2 has reached a low temperature threshold, lying below the critical temperature T_{C} of the antiferromagnetic layer 24, where the first storage magnetization 234 is frozen in the written (or switched) state. Due to the magnetic coupling with the spacer layer 233, the second storage magnetization 235 is oriented anti-parallel with the first storage magnetization 234. The write magnetic field 42 can be applied by passing a write current 41 in a field line 4 in communication with the magnetic tunnel junction 2. The field line is typically disposed on top or below the magnetic tunnel junction 2.

Alternatively, switching the storage magnetization 231 can comprise passing a spin polarized current (not shown) in the magnetic tunnel junction 2, the storage magnetization 231 being then switched according to the spin polarized current polarity.

Data written in the MRAM cell 1 is thus determined by the orientation of the switched magnetization of the storage layer, here the switched second storage magnetization 235 of the second ferromagnetic layer 232, with respect to the orientation of the sense magnetization 211. As discussed above, a low logic state "0" data corresponds to a low resistance (Rₘᵢₙ) of the magnetic tunnel junction 2 and a high logic state "1" data corresponds to a high resistance (Rₘₐₓ) of the magnetic tunnel junction 2.

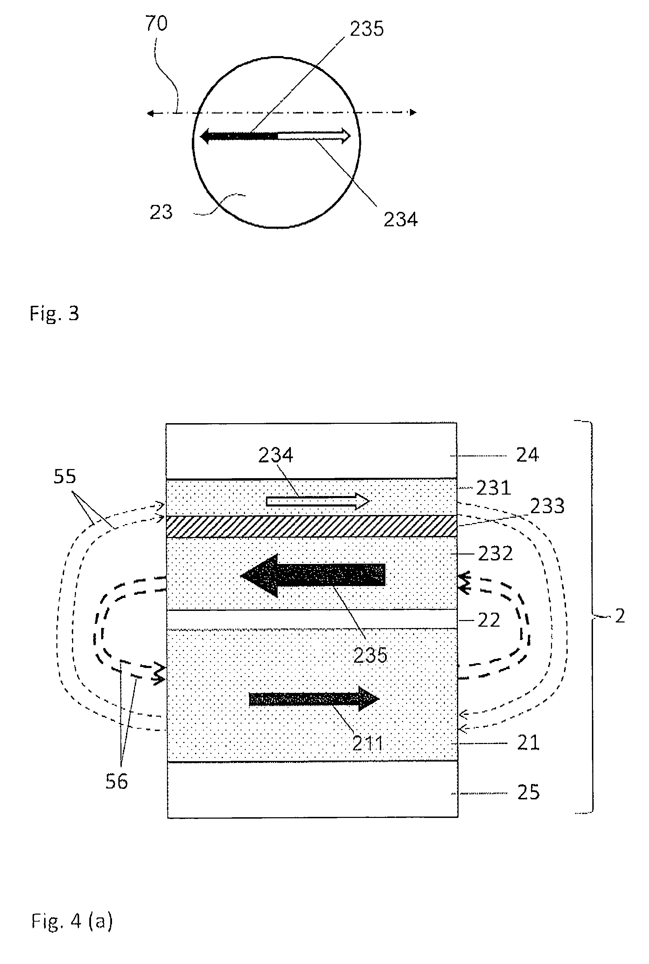

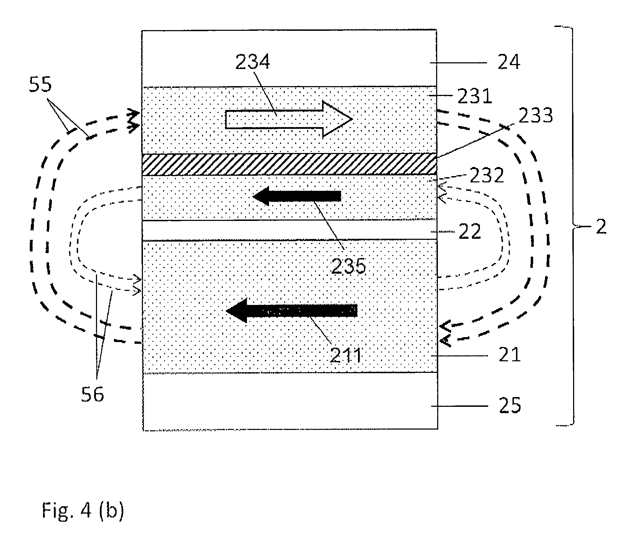

In another embodiment, switching the first storage magnetization 234 is performed by applying the external write magnetic field 42 with a magnitude such as to saturate the sense magnetization 211 in a direction according to the direction of the write magnetic field 42. The saturated sense layer 21 induces in turn a local sense magnetic stray field 60 inducing a coupling between the sense magnetization 211 and the first and second storage magnetizations 234, 235 in a closed magnetic flux configuration (see Fig. 2). More particularly, in the case the second storage magnetization 235 is greater than the first storage magnetization 234, for example when the thickness t2 of the second ferromagnetic layer 232 is greater than the thickness t1 of the first ferromagnetic layer 231 (see Fig. 4(a)), the second storage magnetization 235 is switched in accordance with the local sense magnetic stray field 60, Due to the magnetic coupling with the spacer layer 233, the first storage magnetization 234 becomes oriented (or switched) anti-parallel with the second storage magnetization 235. Alternatively, in the case the first storage magnetization 234 is greater than the second storage magnetization 235, for example when the thickness t1 of the first ferromagnetic layer 231 is greater than the thickness t2 of the second ferromagnetic layer 232 (see Fig. 4(b)), the first storage magnetization 234 is switched in accordance with the local sense magnetic stray field 60, Again, due to the magnetic coupling with the spacer layer 233, the second storage magnetization 235 is oriented anti-parallel with the first storage magnetization 234. Since the distance between the first and second ferromagnetic layers 231, 232 and the sense layer 21 is small, typically in the nanometer the first and second ferromagnetic layers 231, 232 are more effectively coupled with the sense magnetization 211 than with the write magnetic field 42 generated by the field line 4.

The sense magnetization 211, and thus the magnitude of the local sense magnetic stray field 60, can also be varied with the thickness tₛ of the sense layer 21. For example, the sense magnetization 211 can be increased with increasing the thickness tₛ of the sense layer 21. In an embodiment, the thickness tₛ of the sense layer 21 is such that the sense magnetization 211 is greater than the sum of the first and second storage magnetizations 234, 235, or net storage magnetization. Preferably, the thickness tₛ of the sense layer 21 is such that the magnitude of the write magnetic field 42 required to saturate the sense magnetization 211 can be below about 80 Oe. The magnitude of the local sense magnetic stray field 60 can be further increased by providing the sense layer 21 with a material that exhibits large spontaneous magnetization. Moreover, the magnitude of the write magnetic field 42 required for saturating the sense magnetization 211 can be further reduced by providing the sense layer 21 having a small anisotropy. The sense layer 21 having small anisotropy can be achieved by depositing the sense layer 21 under conditions allowing minimum anisotropy in the sense layer 21 thin film. Such minimum anisotropy can also be obtained by depositing the sense layer 21 having a substantially circular shape (circular patterning), such as shown in Fig. 3. More particularly, Fig. 3 represents a top view of the synthetic storage layer 23 showing the first storage magnetization 234 oriented anti-parallel o the second storage magnetization 235, and the anisotropy axis 70 corresponding to the easy axis of the first and second ferromagnetic layers 231, 232.

A read operation of the MRAM cell 1 comprises a first read cycle comprising applying a first read magnetic field 52 adapted for aligning the sense magnetisation 211 in a first direction, in accordance with the first orientation of the first read magnetic field 52. The first read magnetic field 52 can be applied by passing a first read field current 51 having a first polarity in the field line 4. The first direction of the sense magnetization 211 is then compared with the second storage magnetisation 235 by passing a sense current 32 though the magnetic tunnel junction 2. The voltage measured across the magnetic tunnel junction 2 yields a corresponding first resistance value R₁ of the magnetic tunnel junction 2. In the case the sense magnetization 211 is aligned substantially parallel to the first storage magnetization 235 the first resistance value R₁ is small (R₁ = Rₘᵢₙ). On the other hand, when the sense magnetization 211 is aligned substantially antiparallel to the second storage magnetization 235 the measured first resistance value is high (R₁ = Rₘₐₓ). As described in patent application EP2276034, the first resistance value R₁ can be compared to a reference resistance typically halfway between Rₘᵢₙ and Rₘₐₓ.

Preferably, the read operation of the MRAM-based cell 1 further comprises a second read cycle comprising applying a second read magnetic field 54 adapted for aligning the sense magnetization 211 in a second direction opposed to the first direction, in accordance with the second orientation of the second read magnetic field 54. The second read magnetic field 54 can be applied by passing a second read field current 53 having a second polarity in the field line 4. The second direction of the sense magnetization 211 is then compared with the second storage magnetization 235 by passing the sense current 32 though the magnetic tunnel junction 2. Measuring a voltage across the magnetic tunnel junction 2 when the sense current 32 is passed through the magnetic tunnel junction 2 yields a corresponding second resistance value R₂ of the magnetic tunnel junction 2.

The write data written in the MRAM cell 1 can then be determined by a difference between the second resistance value R₂, and the first resistance value R₁ measured in the first read cycle. The difference between the first and second resistance values R₁, R₂, is also called magnetic tunnel magnetoresistance or magnetoresistance ΔR. The difference between the stored first resistance value R₁ and the second resistance value R₂ can yield a negative or positive magnetoresistance ΔR.

In an embodiment, the thickness t1 of the first ferromagnetic layer 231 and the thickness t2 of the second ferromagnetic layer 232 are selected such that the net local magnetic stray field coupling the storage layer 23 with the sense layer 21 (or simply said in the following text: the net local magnetic stray field coupling the sense layer 21) is about 50 Oe or below.

In another embodiment, the thickness t1 of the first ferromagnetic layer 231 and the thickness t2 of the second ferromagnetic layer 232 are selected such that the first local magnetic stray field 55 has substantially the same amplitude than the second local magnetic stray field 56. In this case, the net local magnetic stray field coupling the sense layer 21 is substantially null. In the absence of the net local magnetic stray field, the switching field of the sense layer 21, i.e., the magnitude of the first and second read magnetic fields 52, 54 required for switching the sense magnetization 211, is reduced. For example, the magnitude of the first and second read magnetic fields 52, 54 can be as low as about 20 Oe. The magnitude of the first and second read magnetic fields 52, 54 can be further decreased by using magnetically soft materials, or having low coercivity, such as NiFe-based alloys. Moreover, the magnitude of the first and second read magnetic fields 52, 54 can be further decreased by providing the sense layer 21 with a small anisotropy, for example, the sense layer 21 having a substantially circular shape. However, the sense layer 21 having a reduced switching field results in first storage layer 231 requiring the write magnetic field 42 to have an increase magnitude for switching its first storage magnetization 234.

In yet another embodiment, the thickness t1 of the first ferromagnetic layer 231 and the thickness t2 of the second ferromagnetic layer 232 are selected such that the net local magnetic stray field coupling the sense layer 21 is small but non-null. For example, the net local magnetic stray field coupling the sense layer 21 can be comprised between about 40 Oe and about 50 Oe. Since the magnitude of the first and second local magnetic stray fields 55, 56 depends by the thickness t1, t2 of the first and second ferromagnetic layers 231, 232, respectively, the direction of the resulting local magnetic stray field can be controlled by selecting appropriate the thickness t1 of the first ferromagnetic layer 231 and the thickness t2 of the second ferromagnetic layer 232. Fig. 4 (a) shows a configuration of the magnetic tunnel junction 2 wherein the thickness t2 of the second ferromagnetic layer 232 is greater than the thickness t1 of the first ferromagnetic layer 231, resulting in a larger second storage magnetization 235 and a larger second local magnetic stray field 56. Fig. 4 (b) shows another configuration wherein the thickness t1 of the first ferromagnetic layer 231 is greater than the thickness t2 of the second ferromagnetic layer 232, resulting in a larger first storage magnetization 234 and a large first local magnetic stray field 55.

In this case, the second read cycle can comprise comparing the first resistance value R₁ measured in the first read cycle with the second resistance value R₂ of the magnetic tunnel junction 2 in the absence of applied read magnetic field, for example, with the second read magnetic field 54 being substantially null. In other words, the second read cycle comprises switching the sense magnetization 211 according to the net local magnetic stray field resulting from the first and second local magnetic stray fields 55, 56. The sense magnetization 211 is oriented substantially parallel according to the direction of the resulting local magnetic stray field, or according to the first or second local magnetic stray fields 55, 56 having the highest magnitude. The direction of the sense magnetization 211 can then be determined by selecting the thickness t1, t2 of the first and second ferromagnetic layers 231, 232 as discussed above. Depending on the orientation of the sense magnetizations 211, parallel or anti-parallel with the second storage magnetization 235, the second resistance value R₂ will be minimum or maximum, respectively. The read operation performed in the absence of the second read magnetic field 54 allows for a lower consumption and does also not require a reference resistance.

In another embodiment not represented, the storage layer 23 comprises only the first ferromagnetic layer 231. During the read operation, the first ferromagnetic layer 231 can induce the first local magnetic stray field 55 coupling the first ferromagnetic layer 231 with the sense layer 21. The magnitude of the first local magnetic stray field 55 depends on the first storage magnetization 234 and in the thickness of the first ferromagnetic layer 231 (or storage layer 23). In an embodiment, the second read cycle comprises measuring the second resistance value R₂ in the absence of applied read magnetic field. In other words, the second read cycle comprises aligning the sense magnetization 211 in the second direction by the first local magnetic stray field 55 induced by the first ferromagnetic layer 231. The sense magnetization 211 will then be oriented parallel with the direction of the first local magnetic stray field 55.

A magnetic memory device (not represented) can comprise a plurality of the MRAM cells 1 arranged in rows and columns. The magnetic memory device can further comprise one or a plurality of the field line 4 that connect the MRAM cells 1 along a row, and one or a plurality of the current line 5 coupled to the MRAM cells 1 along a column. The magnetic memory device can further comprise a device package, the plurality of the MRAM cells 1 being disposed within the device package.

### Reference numbers

- 1: magnetic random access memory (MRAM) cell
- 2: magnetic tunnel junction
- 21: sense layer
- 211: sense magnetization
- 22: tunnel barrier layer
- 23: synthetic storage layer
- 231: first ferromagnetic layer
- 232: second ferromagnetic layer
- 233: spacer layer
- 234: first storage magnetisation
- 235: second storage magnetization
- 24: antiferromagnetic layer
- 25: electrode
- 31: heating current
- 32: sense current
- 4: field line
- 41: write current
- 42: write magnetic field
- 5: current line
- 51: first read field current
- 52: first read magnetic field
- 53: second read field current
- 54: second read magnetic field
- 55: first local magnetic stray field
- 56: second local magnetic stray field
- 60: sense magnetic stray field
- 70: anisotropy axis

- R₁: first resistance value
- R₂: second resistance value
- T_{C}: critical temperature
- t1: thickness of the first ferromagnetic layer
- t2: thickness of the second ferromagnetic layer
- t_{S}: thickness of the sense layer

## Claims

1. A magnetic random access memory (MRAM) cell (1) comprising a magnetic tunnel junction (2) comprising:
a synthetic storage layer (23) formed from a first ferromagnetic layer (231) having a first storage magnetization (234), a second ferromagnetic layer (232) having a second storage magnetization (235) and a spacer layer (233) between the first and second ferromagnetic layers (231, 232), the spacer layer (233) magnetically coupling the first and second ferromagnetic layers (231, 232) such that the first storage magnetization (234) is oriented substantially anti-parallel with the second magnetization (235);
a sense layer (21) having a sense magnetization (211)that is reversible; and
a tunnel barrier layer (22) between the sense layer (21) and the storage layer (23);
the first storage magnetization (234) inducing a first local magnetic stray field (55) and the second storage magnetization (235) inducing a second local magnetic stray field (56), the difference between the first and second local magnetic stray fields (55, 56) corresponding to a net local magnetic stray field coupling the sense layer (21);
**characterized in that**
the thickness (t1) of the first ferromagnetic layer (231) and the thickness (t2) of the second ferromagnetic layer (232) are selected such that the net local magnetic stray field coupling the sense layer (21) is below about 50 Oe.

2. MRAM cell (1) according to claim 1, wherein
the thickness (t1) of the first ferromagnetic layer (231) and the thickness (t2) of the second ferromagnetic layer (232) are selected such that the net local magnetic stray field coupling the sense layer (21) is substantially null.

3. MRAM cell (1) according to the claims 1 or 2, wherein
the thickness (t1) of the first ferromagnetic layer (231) and the thickness (t2) of the second ferromagnetic layer (232) are selected such that the net local magnetic stray field coupling the sense layer (21) is comprised between about 40 Oe and about 50 Oe.

4. MRAM cell (1) according to any one of claims 1 to 3, wherein the sense layer (21) has a substantially circular shape.

5. A magnetic memory device comprising a plurality of the MRAM cells (1) **characterized by** any one of claims 1 or 4.

6. A method for writing the MRAM cell (1) **characterized by** any one of claims 1 or 4, comprising:
heating the magnetic tunnel junction (2) to a high temperature threshold; and,
once the magnetic tunnel junction (2) has reached the high temperature threshold, switching the magnetization direction of the first and second storage magnetizations (234, 235) to write data to said storage layer (23); wherein
switching the magnetization direction of the first and second storage magnetizations (234, 235) comprises applying an external write magnetic field (42).

7. Method according to claim 6, wherein
the write magnetic field (42) is applied with a magnitude that is comprised between about 130 Oe and about 160 Oe.

8. Method according to claim 6, wherein
said switching the first and second storage magnetizations (234, 235) comprises applying the external write magnetic field (42) having a magnitude such as to saturate the sense magnetization (211) in a direction according to the direction of the write magnetic field (42); the first and second storage magnetizations (234, 235) being switched in accordance with alocal sense magnetic stray field (60) induced by the saturated sense magnetization (211).

9. Method according to claim 8, wherein
the thickness (tₛ) of the sense layer (21) is such that the sense magnetization (211) is greater than the sum of the first and second storage magnetizations (234, 235).

10. Method according to claim 9, wherein
thickness (tₛ) of the sense layer (21) is such that the magnitude of the write magnetic field (42) required to saturate the sense magnetization (211) is below about 80 Oe.

11. A method for reading the MRAM cell (1) **characterized by** any one of claims 1 or 4, comprising:
aligning the sense magnetization (211) in a first direction by applying a first read magnetic field (52);
measuring a first resistance (R₁) of said magnetic tunnel junction (2), the first resistance (R₁) being determined by the first direction of the sense magnetization (211) relative to the orientation of switched the storage magnetization (234);
aligning the sense magnetization (211) in a second direction;
measuring a second resistance (R₂) of said magnetic tunnel junction (2), the second resistance (R₂) being determined by the second direction of the sense magnetization (211) relative to the orientation of the switched storage magnetization (234);
determining a difference between the first resistance value and the second resistance value;
said aligning the sense magnetization (211) in a second direction comprises applying a second read magnetic field (54) having a magnitude of about 50 Oe or below.

12. Method according to claim 11, wherein
the thickness (t1) of the first ferromagnetic layer (231) and the thickness (t2) of the second ferromagnetic layer (232) are selected such that the net local magnetic stray field coupling the sense layer (21) is substantially null.

13. Method according to claim 12, wherein
the magnitude of the first and second read magnetic fields (52, 54) is about 20 Oe.

14. Method according to claim 11, wherein
the thickness (t1) of the first ferromagnetic layer (231) and the thickness (t2) of the second ferromagnetic layer (232) are selected such that the net local magnetic stray field coupling the sense layer (21) is comprised between about 40 Oe and about 50 Oe.

15. Method according to claim 14, wherein the second read magnetic field (54) is substantially null.

## Patentansprüche

1. Eine magnetische Direktzugriffsspeicherzelle (1) (MRAM-Zelle) aufweisend einen magnetischen Tunnelübergang (2) aufweisend:
ein synthetische Speicherschicht (23) geformt von einer ersten ferromagnetischen Schicht (231) mit einer ersten Speichermagnetisierung (234), einer zweiten ferromagnetischen Schicht (232) mit einer zweiten Speichermagnetisierung (235) und einer Abstandshalteschicht (233), die die erste und zweite ferromagnetische Schichten (231, 232) magnetisch koppelt, so dass die erste Speichermagnetisierung (234) grundsätzlich anti-parallel zu der zweiten Magnetisierung (235) ausgerichtet ist;
eine Messschicht (21) mit einer Messmagnetisierung (211), die reversibel ist; und
eine Tunnelbarrierenschicht (22) zwischen der Messschicht (21) und der Speicherschicht (23);
wobei die erste Speichermagnetisierung (234) ein erstes lokales magnetisches Streufeld (55) und die zweite Speichermagnetisierung (235) eine zweites lokales Streufeld (56) aufweist, wobei der Unterschied zwischen dem ersten und zweiten lokalen magnetischen Streufeldern (55, 56) entsprechend eines lokalen magnetischen Nettostreufeld mit der Messschicht (21) koppelt;
**dadurch gekennzeichnet, dass**
die Dicke (t1) der ersten ferromagnetischen Schicht (231) und die Dicke (t2) der zweiten ferromagnetischen Schicht (232) so gewählt sind, dass die lokale magnetische Nettostreufeldkopplung mit der Messschicht (21) unterhalb von 50 Oe ist.

2. MRAM-Zelle (1) nach Anspruch 1, wobei die Dicke (t1) der ersten ferromagnetischen Schicht (231) und die Dicke (t2) der zweiten ferromagnetischen Schicht (232) so gewählt werden, dass die lokale magnetische Nettostreufeldkopplung mit der Messschicht (21) grundsätzlich Null ist.

3. MRAM-Zelle (1) nach Anpsruch 1 oder 2, wobei die Dicke (t1) der ersten ferromagnetischen Schicht (231) und die Dicke (t2) der zweiten ferromagnetischen Schicht (232) so gewählt werden, dass die lokale magnetische Nettostreufeldkopplung mit der Messschicht (21) zwischen ungefähr 40 Oe und ungefähr 50 Oe ist.

4. MRAM-Zelle (1) nach einem der Ansprüche 1 bis 3, wobei die Messschicht (21) grundsätzlich kreisförmige Form hat.

5. Ein magnetisches Speichergerät aufweisend eine Mehrzahl einer MRAM-Zelle (1) nach einem der Ansprüche 1 bis 4.

6. Ein Verfahren zum Beschreiben einer MRAM-Zelle (1) nach einem der Ansprüche 1 bis 4:
Aufheizen des magnetischen Tunnelübergangs (2) auf eine hohen Temperaturschwellwert; und
sobald der magnetische Tunnelübergang (2) den hohen Temperaturschwellwert erreicht hat, Umschalten der Magnetisierungsrichtung der ersten und zweiten Magnetisierungsrichtungen (234, 235), um Daten auf die Speicherschicht (23) zu schreiben; wobei
das Umschalten der Magnetisierungsrichtung der ersten und zweiten Speichermagnetisierungen (234, 235) das Anwenden eines externen magnetischen Schreibfelds (42) aufweist.

7. Verfahren nach Anspruch 6, wobei
das magnetische Schreibfeld (42) mit einer Grösse zwischen ungefähr 130 Oe und ungefähr 160 Oe angewandt wird.

8. Verfahren nach Anspruch 6, wobei
das Umschalten der ersten und zweiten Speichermagnetisierungen (234, 235) das Anwenden des externen magnetischen Schreibfelds (42) mit einer Grösse aufweist, so dass die Messmagnetisierung (211) in einer Richtung entsprechend der Richtung des magnetischen Schreibfelds (42) gesättigt wird; wobei die erste und zweite Speichermagnetisierungen (234, 235) entsprechend eines lokalen magnetischen Messstreufelds (60), das durch die gesättigte Messmagnetisierung (211) induziert wird, umgeschaltet wird.

9. Verfahren nach Anspruch 8, wobei die Dicke (tₛ) der Messschicht (21) so ist, dass die Messmagnetisierung (211) grösser als die Summe der ersten und zweiten Speichermagnetisierung (234, 235) ist.

10. Verfahren nach Anspruch 9, wobei die Dicke (tₛ) der Messschicht (21) so ist, dass die Grösse des magnetischen Schreibfelds (42), das zur Sättigung der Messmagnetisierung (211) notwendig ist, unterhalb von ungefähr 80 Oe liegt.

11. Ein Verfahren zum Auslesen einer MRAM-Zelle (1) nach einem der Ansprüche 1 bis 4, aufweisend:
Ausrichten der Messmagnetisierung (211) in eine erste Richtung durch Anwenden eines ersten magnetischen Lesefelds (52);
Messen eines ersten Widerstands (R1) des magnetischen Tunnelübergangs (2), wobei der erste Widerstand (r1) durch die erste Richtung der Messmagnetisierung (211) relativ zu der Orientierung der umgeschalteten Speichermagnetisierung (234) bestimmt wird;
Ausrichten der Messmagnetisierung (211) in eine zweite Richtung;
Messen eines zweiten Widerstands (R2) des magnetischen Tunnelübergangs (2), wobei der zweite Widerstand (r1) durch die zweite Richtung der Messmagnetisierung (211) relativ zu der Orientierung der umgeschalteten Speichermagnetisierung (234) bestimmt wird;
Bestimmen des Unterschieds zwischen dem ersten Widerstandswerts und des zweiten Widerstandswerts;
wobei das Ausrichten der Messmagnetisierung (211) in eine zweite Richtung das Anwenden eines zweiten magnetischen Lesemagnetfelds (54) mit einer Grösse von ungefähr 50 Oe oder kleiner aufweist.

12. Verfahren nach Anspruch 11, wobei die Dicke (t1) der ersten ferromagnetischen Schicht (231) und die Dicke (t2) der zweiten ferromagnetischen Schicht (232) so gewählt werden, dass die lokale magnetische Nettostreufeldkopplung mit der Messschicht (21) grundsätzlich Null ist.

13. Verfahren nach Anspruch 12, wobei
die Grösse der ersten und zweiten magnetischen Lesefelder (52, 54) ungefähr 20 Oe ist.

14. Verfahren nach Anspruch 11, wobei die Dicke (t1) der ersten ferromagnetischen Schicht (231) und die Dicke (t2) der zweiten ferromagnetischen Schicht (232) so gewählt werden, dass die lokale magnetische Nettostreufeldkopplung mit der Messschicht (21) zwischen ungefähr 40 Oe und ungefähr 50 Oe ist.

15. Verfahren nach Anspruch 14, wobei
das zweite magnetische Lesefelde (54) grundsätzlich Null ist.

## Revendications

1. Une cellule MRAM a accès aléatoire (1) comprenant une jonction tunnel magnétique (2) comprenant:
Une couche de stockage synthétique (23) comprenant une première couche ferromagnétique (231) ayant une première aimantation de stockage (234), une deuxième couche ferromagnétique (232) ayant une deuxième aimantation de stockage (235) et une couche d'espacement (233) entre la première couche et la deuxième couche ferromagnétique (231, 232), la couche d'espacement (233) couple magnétiquement la première et la deuxième couche ferromagnétique (231, 232) de telle sorte que la première aimantation de stockage soit orientée essentiellement de façon antiparallèle avec la deuxième aimantation de stockage (235).
Une couche de détection (21) possédant une aimantation de détection (211) réversible; et
Une couche barrière à effet tunnel (22) entre la couche de détection (21) et la couche de stockage (23);
la première aimantation de stockage (234) induit un premier champ magnétique local rayonné (55) et la deuxième aimantation de stockage (235) induit un deuxième champ magnétique local parasite (56), la différence entre le premier et le deuxième champ magnétique local parasite (55, 56) correspond à une champ magnétique parasite local net couplant la couche de détection (21);
**caractérisée en ce que**:
l'épaisseur (1) de la première couche ferromagnétique (231) et l'épaisseur (t2) de la deuxième couche ferromagnétique (232) soient sélectionnés de telle sorte que le champ magnétique local net rayonné couplant la couche de détection (21) soit en dessous d'environ 50 Oe.

2. cellule MRAM (1) selon la revendication 1, dans laquelle l'épaisseur (t1) de la première couche ferromagnétique (231) et l'épaisseur (t2) de la deuxième couche ferromagnétique (232) sont sélectionnées de telle sorte que le champ magnétique local parasite net couplant la couche de détection (21) soit essentiellement nul.

3. Cellule MRAM (1) selon l'une des revendications 1 ou 2, dans laquelle
l'épaisseur (t1) de la première couche ferromagnétique (231) et l'épaisseur (t2) de la deuxième couche ferromagnétique (232) sont sélectionnées de telle sorte que le champ magnétique local net parasite couplant la couche de détection (21) soit compris entre environ 40 Oe et environ 50 Oe.

4. Cellule MRAM (1) selon l'une quelconque des revendications 1 à 3, dans laquelle
la couche de détection (21) a essentiellement une forme circulaire.

5. Un dispositif de mémoire magnétique comprenant une pluralité de cellules MRAM (1) **caractérisée par** l'une quelconque des revendications 1 à 4.

6. Une méthode pour écrire une cellule MRAM **caractérisée par** l'une quelconque des revendications 1 ou 4, comprenant:
le chauffage de la jonction tunnel magnétique (2) à une température de seuil élevée; et,
une fois que la jonction tunnel magnétique (2) ait atteint la température de seuil élevée, commutation de la direction de l'aimantation de la première et de la deuxième aimantation de stockage (234, 235) pour écrire les données sur ladite couche de stockage (23); dans laquelle
la commutation de la direction de l'aimantation de la première et de la deuxième aimantation de stockage (234, 235) comprends l'application d'un champ magnétique externe d'écriture (42).

7. Méthode selon la revendication 6, dans laquelle le champ magnétique écrit (42) est appliqué avec une amplitude qui est comprise entre environ 130 Oe et environ 160 Oe.

8. Méthode selon la revendication 6, dans laquelle ladite commutation de la première et de la deuxième aimantation de stockage (234, 235) comprends l'application d'un champ magnétique externe d'écriture (42) avec une amplitude telle qu'à saturer l'aimantation de détection (211) dans une direction selon la direction du champ magnétique d'écriture (42); la première et de la deuxième aimantation de stockage (234, 235) étant commutées en concordance avec un champ magnétique local de détection rayonné (60) induit par l'aimantation de détection saturée (211).

9. Méthode selon la revendication 8, dans laquelle l'épaisseur (tₛ) de la couche de détection (21) est telle que l'aimantation de détection (211) soit plus grande que la somme la première et de la deuxième aimantation de stockage (234, 235).

10. Méthode selon la revendication 9, dans laquelle l'épaisseur (tₛ) de la couche de détection (21) est telle que l'amplitude du champ magnétique d'écriture (42) requise pour saturer l'aimantation de détection (211) soit en dessous 80 Oe.

11. Une méthode pour lire la cellule MRAM (1) **caractérisée par** l'une quelconque des revendications 1 ou 4, comprenant
l'alignement de l'aimantation de détection (211) dans la première direction en appliquant un premier champ magnétique de lecture (52);
la mesure d'une première résistance (R₁) de ladite jonction tunnel magnétique (2), la première résistance (R₁) étant déterminée par la première aimantation de détection (211) par rapport à l'orientation de l'aimantation de stockage saturée (234);
l'alignement de l'aimantation de détection (211) dans une deuxième direction;
la mesure d'une deuxième résistance (R₂) de ladite jonction tunnel magnétique (2), la deuxième résistance (R₂) étant déterminée par la deuxième direction de l'aimantation de détection (211) par rapport à l'orientation de l'aimantation de stockage commutée (234);
la détermination d'une différence entre la première valeur de résistance et la deuxième valeur de résistance;
ledit alignement de l'aimantation de détection (211) dans une deuxième direction comprends l'application d'un deuxième champ magnétique de lecture (54) avec une amplitude d'environ 50 Oe ou en dessous.

12. Méthode selon la revendication 11, dans laquelle l'épaisseur (t1) de la première couche ferromagnétique (231) et l'épaisseur (t2) de la deuxième couche ferromagnétique (232) sont sélectionnées de telle sorte que le champ magnétique local net rayonné couplant la couche de détection (21) soit essentiellement nul.

13. Méthode selon la revendication 12, dans laquelle l'amplitude du premier et du deuxième champ magnétique lu (52, 54) est environ 20 Oe.

14. 12. Méthode selon la revendication 11, dans laquelle l'épaisseur (t1) de la première couche ferromagnétique (231) et l'épaisseur (t2) de la deuxième couche ferromagnétique (232) sont sélectionnées de telle sorte que le champ magnétique local net rayonné couplant la couche de détection (21) soit compris entre environ 40 Oe et environ 50 Oe.

15. Méthode selon la revendication 14, dans laquelle le deuxième champ magnétique de lecture (54) est essentiellement nul.
